# EUROPEAN PATENT APPLICATION

(11) **EP 1 429 233 A1**
(43) Date of publication of application: **16.06.2004**
(21) Application number: 02354193.1
(22) Date of filing: 13.12.2002
(51) Int. Cl.: G06F 1/18, H05K 7/14, G11B 33/12

(54) **component support system**

(71) Applicant: Hewlett-Packard Company, Palo Alto, CA 94304 (US)
(72) Inventor: Astier, Christian, 38420 Domene (FR); Rieuvernet, Pierre, 38330 Montbonnot st Martin (FR); Lelong, Stephane, 38410 Vaulnaveys le Haut (FR)
(74) Representative: Lloyd, Richard Graham

(57) **Abstract**

A computer including a casing (180) is provided with a component support system (10) for supporting a component (34), such as a disc drive. The support system (10) includes a frame (14) within which the component (34) is located; a handle (16) attached to the frame (16); and first and second latches (18, 22) formed on the frame (14). The latches (18, 22) are operably coupled to the handle (16) and can deform between an engaging position and a non-engaging position. The handle (16) is also deformable upon the application of a force thereto to deform the latches (18, 22) into the non-engaging position. The support system provides a relatively easy method of replacing computer components.

## Description

### Field of the Invention:

The present invention relates to a component support system for use, for example, in supporting disc drives and similar components within a computer.

### Background of the Invention:

Computer components are supported within the computer, typically to the casing or a chassis of the computer. The most common way to achieve this has been by use of screws which screw into threaded recesses located in the case of the component.

While such methods are effective in supporting components within a computer, the removal of the component, for example for repair or replacement, is not considered a simple matter by the user. As a result, users tend to insist that this task is carried out by specialist service personnel, usually from the computer company or an associated support company. This adds significant cost and logistical problems both to the user and to the computer or service company, for the latter particularly when the computer is under warranty.

Attempts have been made to simplify how components are supported in a computer system, with the aim to have the user himself/herself carry out the task of component replacement. If this can be achieved, one can avoid either having to ship the computer back to the supplier or manufacturer or having service personnel visit the user's premises to carry out the replacement.

One prior art system is disclosed in United States patent no. 6,299,266. This patent discloses a system in which a computer component such as a disc drive can be removed from a personal computer without having to open the computer casing and without the need to remove screws. The fixing of the component to the computer is achieved via a removable tray which is provided with a plurality of posts which fit in to associated recesses in the case of the component. These pins also provide for the ground connection for the component. However, a user is required to use both hands to remove or insert a peripheral component via this system, which can sometimes be inconvenient and thus discourage the user to carry out this action. Moreover, the tray and fixing clips add cost to the system.

### Summary of the Present Invention:

The present invention seeks to provide an improved component support system.

According to an aspect of the present invention, there is provided a component support system for supporting a component of a computer including a frame within which a said component can be located; a handle attached to the frame; and at least one latch on the frame, which latch is operably coupled to the handle and is configurable between an engaging configuration and a non-engaging configuration; wherein the handle is deformable upon the application of a force thereto and, upon such deformation, is operable to move the at least one latch to the non-engaging position.

Advantageously, the at least one latch is formed within the frame as a deformable part of the frame.

In the preferred embodiment, there are provided two latches, one either side of the handle.

In the preferred embodiment, the frame has internal dimensions larger than the external dimensions of the component.

Preferably, the component support system is provided with at least one ground terminal coupled to the frame. Advantageously, the ground terminal is movable relative to the frame. In the preferred embodiment, the at least one ground terminal is in the form of a pin designed to engage into a recess of a said component.

Preferably, there is provided a plurality of ground terminals on a plurality of metallic terminal supports.

The frame is preferably disengageable from the component, such as for re-use.

The system preferably includes a sub-chassis within which the frame can be fixed, the sub-chassis including at least one abutment co-operable with said at least one latch, wherein, when the at least one latch is in the engaging configuration, the frame is latched into the sub-chassis.

It is envisaged that the sub-chassis would be substantially permanently fixed within a computer casing or chassis, such as by screws, riveting or welding and so on, or by being formed integrally therewith.

According to another aspect of the present invention, there is provided a computer including a component support system for supporting which includes a frame within which a computer component can be located; a handle attached to the frame; and at least one latch on the frame, which latch is operably coupled to the handle and is configurable between an engaging configuration and a non-engaging configuration; wherein the handle is deformable upon the application of a force thereto and, upon such deformation, is operable to move the at least one latch to the non-engaging position to allow removal of the frame from the computer.

Preferably, the computer is a personal computer.

According to an aspect of the present invention, there is provided a component assembly including a component and a component support system as herein specified.

According to another aspect of the present invention, there is provided a component support system for supporting a component of a computer including a frame within which a said component can be located; a handle attached to the frame; and first and second latches formed on the frame, the latches being operably coupled to the handle and deformable between an engaging position and a non-engaging position; the handle being deformable upon the application of a force thereto to deform the latches into the non-engaging position.

According to another aspect of the present invention, there is provided a computer including a component and a component support system supporting the component, the component support system including a frame within which the component is located; a handle attached to the frame; and first and second latches formed on the frame, the latches being operably coupled to the handle and deformable between an engaging position and a non-engaging position; the handle being deformable upon the application of a force thereto to deform the latches into the non-engaging position.

In the preferred embodiment, the computer casing includes a removable front bezel which in use covers the handle.

The component support system allows the easy removal and replacement of computer components, for example disc drives and the like. In particular, such removal and replacement is sufficiently simple that a user with even little confidence can carry out this task, simply by removing the front bezel and pulling on the handle, upon which the computer component is extracted from the computer. Replacement of that component can be achieved simply by pushing the frame back into the sub-chassis (which will appear as a slot within the front of the computer casing) and refitting of the front bezel. These tasks are simple to carry out and thereby can reduce the need for them to be carried out by a service engineer.

The frame can also act as a protective element around the component and can usefully be supplied with the component itself. Thus, the component can be protected during transport and handling.

The floating nature of the ground terminal provides for manufacturing tolerances in the size of the component case. Moreover, they allow a certain amount of movement of the component within the frame, which can provide added protection.

### Description of the Drawings:

Embodiments of the present invention are described below, by way of example only, with reference to the accompanying drawings, in which:
Figures 1a and 1b show perspective views of a simplified form of the preferred embodiment of component support system;
Figures 2a and 2b show plan views of the system of Figures 1a and 1b;
Figure 3 shows a perspective view, in disassembled form, of a frame of the preferred embodiment of component system;
Figure 4 shows a perspective view of the frame of Figure 3 in assembled form and including ground terminals;
Figure 5 shows in plan view the frame of Figure 4 with a component mounted therein;
Figure 6 shows a cross-sectional view of part of the frame of Figure 4;
Figure 7 shows a cross sectional view along line A-A of Figure 5;
Figure 8 shows a side elevational view of the frame of Figure 4;
Figure 9 shows an example of computer case within which the preferred embodiment of component support system is located; and
Figure 10 is a plan view of the computer case of Figure 9.

### Description of the Preferred Embodiments:

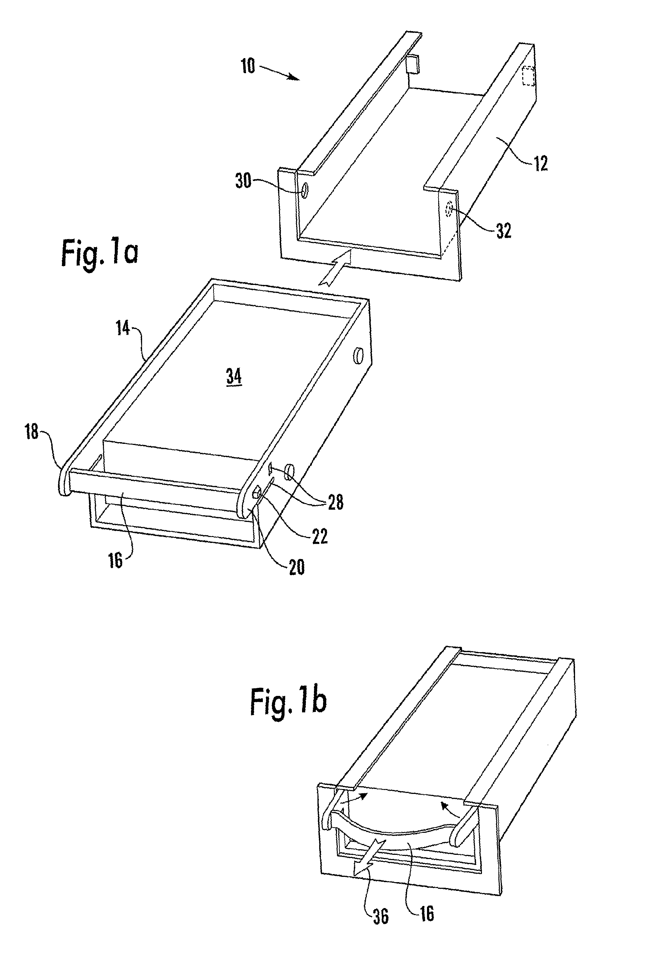

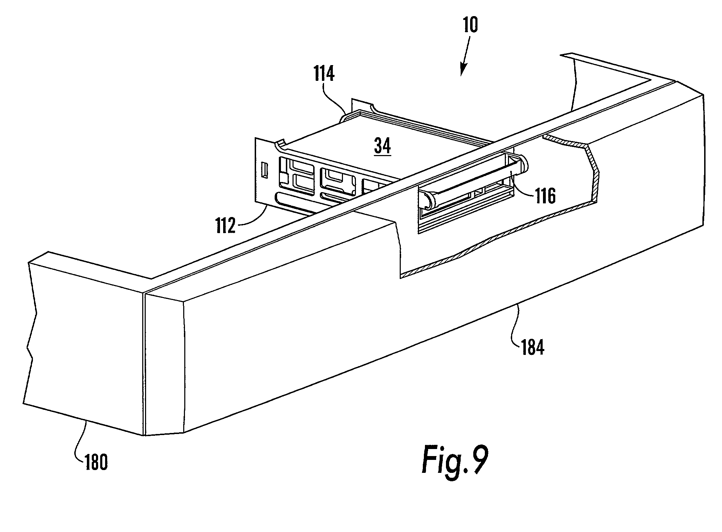

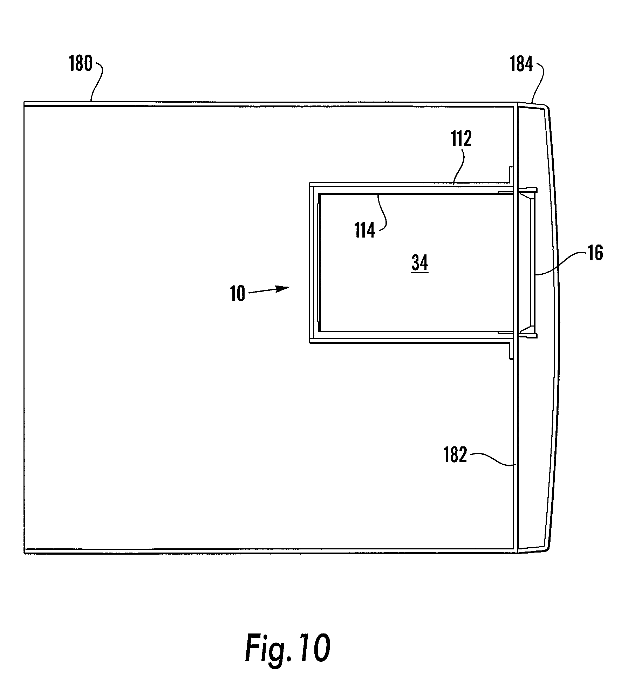

Referring to Figures 1a and 1b, the simplified embodiment of component support system 10 shown includes a sub-chassis 12, typically made of metal or other electrically conductive material. The sub-chassis 12 is designed to be fixed to a computer casing as is described below in connection with Figures 9 and 10.

The system is also provided with a component support frame 14 to which is attached a handle 16. The frame 14 is also provided at a front end with two tabs 18, 20 which are connected to the handle 16 at their forward positions and which are provided on their outer surfaces with positioning posts or latches 22, 24 (only one of the posts being visible in Figure 1a). The tabs 18, 20 extend beyond the front of the frame 14 and can be said to be provided with hinged zones 26, 28, allowing the tabs 18, 20 to be resiliently deformed inwardly when the handle 16 is pulled, as is described below.

The sub-chassis 12 includes two holes 30, 32 which are located to receive the positioning posts 22, 24.

The frame 14 is designed to hold a computer component 34, which in this example is a computer drive, such as a floppy disc drive, hard disc drive, CD-ROM, DVD drive or the like.

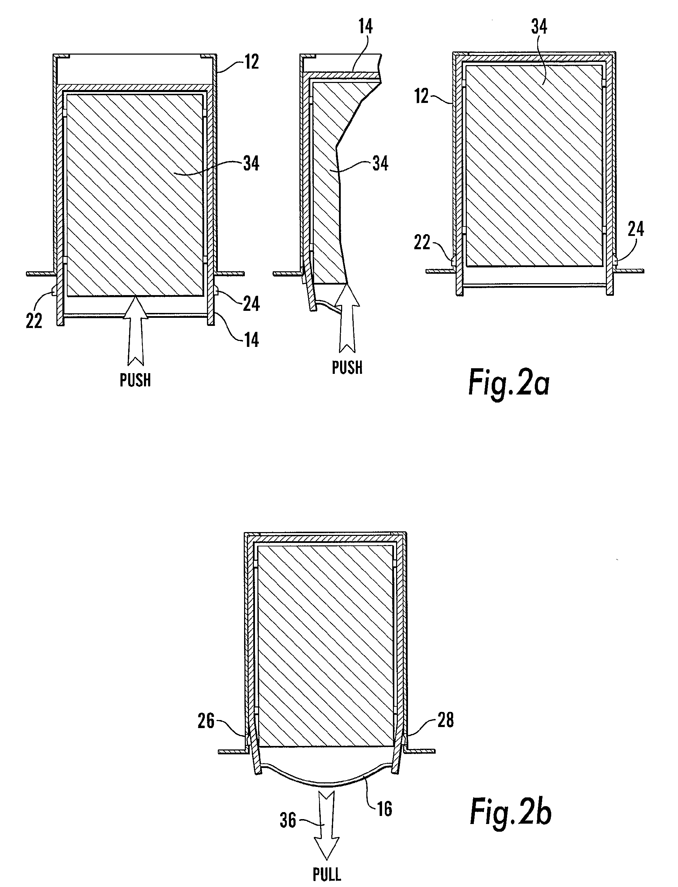

Referring to Figure 2a, the frame 14 and drive 34 are shown in the process of being inserted into the sub-chassis 12. In the left-hand view, the frame 14 has been inserted a substantial distance into the sub-chassis 12 but the support posts 22 remain outside the sub-chassis 12. In the middle view of Figure 2a, the positioning posts 22, 24 abut the front face of the sub-chassis 12. In order to assist the bending of the tabs 18, 20 to allow the support posts 22, 24 to fit into the sub-chassis 12, the rear surfaces of the support posts 22, 24 are bevelled so as to present a non-perpendicular angle to the front face of the sub-chassis 12. This bevelled edges of the positioning posts 22, 24 pushes them inwardly as the frame continues to be pushed into the sub-chassis 12 and thereby biases the tabs 18, 20 inwardly also, as shown in Figure 2a.

In the right hand view of Figure 2a, the frame has been fully inserted into the sub-chassis 12 and the positioning posts 22, 24 are located in the holes 30, 32 of the sub-chassis 12, allowing the tabs 18, 20 to spring back out to their rest (engaged) position. As the front faces of the positioning posts 22, 24 are substantially perpendicular to the side walls of the frame 14, they present a shoulder to the walls forming the holes 30, 32 and secure the frame 14 within the sub-chassis 12.

Referring now to Figures 1b and 2b, when it is desired to remove the component 34 from the computer, the handle 16 is pulled in the direction of the arrow 36. The handle 16 is deformable such that it takes the bowed shape shown in Figures 1b and 2b. By taking this shape, the handle pulls the tabs 18 to 20 inwardly causing these deform, in this example, at their hinged zones 26, 28. In so doing, the tabs 18, 20 pull the positioning posts 22, 24 out of the holes 30, 32 of the sub-chassis 12 and thereby unlock the frame 14 from the sub-chassis 12. The frame and computer component can then be removed from the sub-chassis 12 and thus from the computer.

In the preferred embodiment, the computer provides electrical terminals for connecting the components 34 to the other components of the computer, which are automatically engaged and disengaged upon the simple insertion of the component into the sub-chassis 12. This can be done, for example, by means of a suitable plug and socket arrangement at the rear of the sub-chassis 12 and component 34.

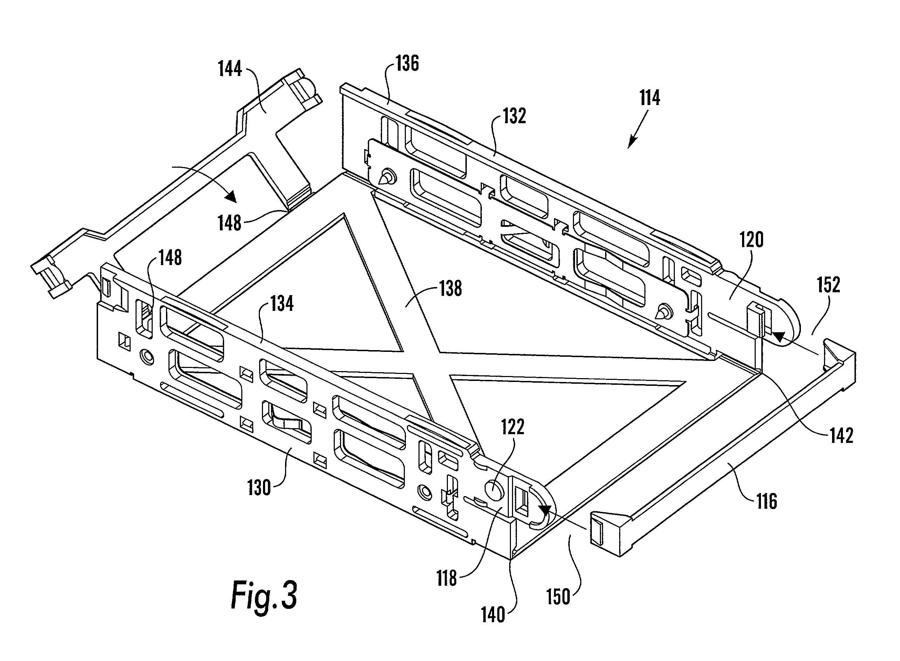

Referring now to Figure 3, a preferred embodiment of frame 114 is shown. This frame 114 is preferably formed of a resilient material, such as a plastics material. It is also of an open design, which in practice allows air to pass to and from the component 34 for cooling purposes.

The frame 114 is provided with side walls 130, 132, each of which has an upper flange 134, 136 which in use is located over the computer component 34 to hold the computer component in place within the frame 114.

The side walls 130, 132 are connected to a base member 138 of the frame 114 by reduced thickness portions 140, 142, which act as hinges to allow the walls 130, 132 to pivot relative to the base member 138.

The frame member 114 is also provided with a back wall 144, hinged at 146, 148, again by a reduced thickness portion. The back wall 144 is provided with side clips 145 which clip onto respective ends of the side walls 130, 132 to secure the back wall 144 in place.

The handle 116 is, in this embodiment, formed as a separate component which is attached to the frame 114 by means of first and second latches 150, 152. The latches 150, 152 provide a snap-fit of the handle 116 to the frame 114.

When the back wall 144 and the handle 116 are fitted to the side walls 130, 132, the frame 114 retains its shape and can thereby hold a drive 34 or other component in place.

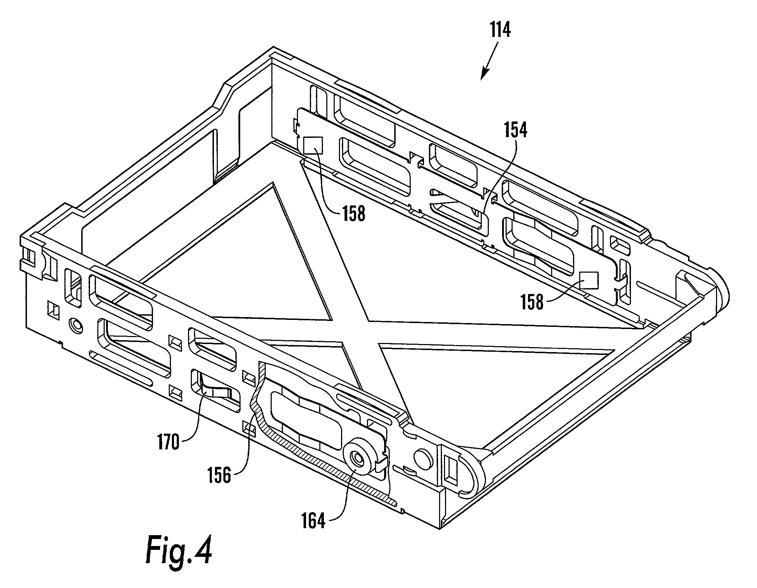

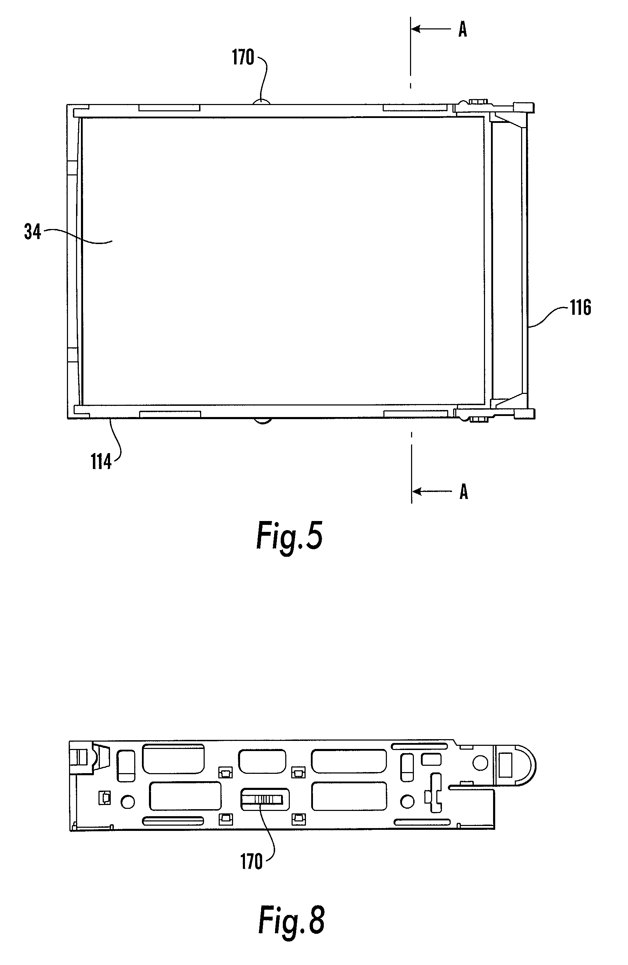

Referring now to Figure 4, located within the frame 114 are first and second elongated metallic ground terminal supports 154, each of which supports two metal ground pins 158. The ground pins 158 fit within appropriate recesses or bores in the casing of component 34 when the component 34 is fitted into the frame 116 in the manner shown in Figure 5.

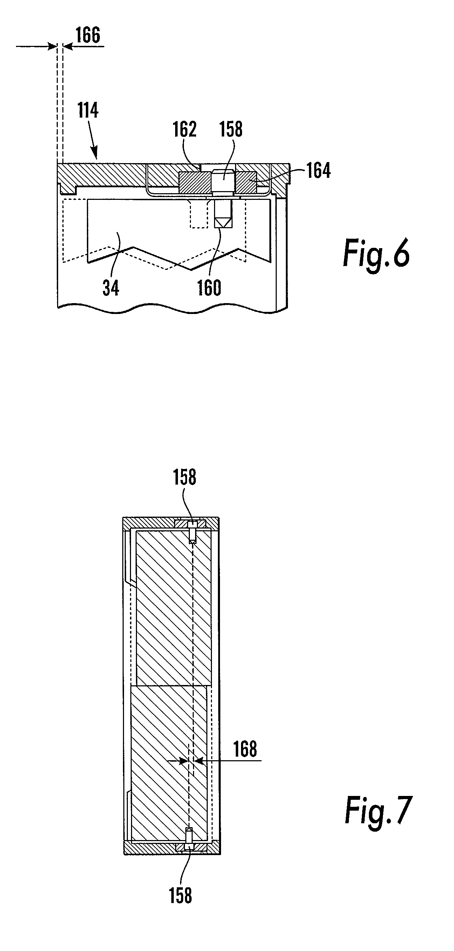

Referring to Figures 6 and 7, there is shown a cross-sectional view of a part of the frame 114 with a component 34 fitted inside. The pins 158 fit within recesses 160 of the component 34. More specifically, as can be seen in the cutaway portion of Figure 4 and in Figure 6 in particular, the pins 158 fit within appropriate recesses 162 in the frame 114 on rubber bushings 164. These allow the pins 158 to move relative to the frame 114 and to make a good, sprung, contact with the recess 160 of the component 34.

As can be seen in Figures 6 and 7, the component 34 fits within the frame 114 with a gap 166 such that the component 34 can move within the frame 114 by a small distance 168 (shown schematically in Figure 7). Not only does this ensure a good electrical connection with the casing of the component 34 but also protects the component 34, particularly when the component 34 is transported in the frame 114.

The members 154, 156 are also provided with ground springs 170 which extend beyond the outer periphery of the frame 114 (as can clearly be seen in Figure 5). In practice, these ground springs 170 will contact the inner walls of the sub-chassis 12 so as to make electrical connection therewith, the sub-chassis 12 typically being connected to ground potential through the computer casing in conventional manner.

The frame 114 shown in Figures 3 to 8 is of a form which provides good protection for the component 34, good support for the component 34 and easy removal and replacement of the component 34 when so desired.

Referring now to Figures 9 and 10, the system 10 can be seen fitted within a computer casing 180 of a personal computer. For ease of understanding, the computer is shown with its top cover removed.

The sub-chassis 112 is fixed to the computer casing 180 by riveting, welding or by any other suitable method. The sub-chassis 112 is also provided with apertures to allow air to flow to and from the component 34 for cooling purposes.

When the frame 114 is fitted into the sub-chassis 112, from the front the computer casing 180, the handle 116 protrudes from the front wall 182 of the computer casing 180, so that it can be easily grasped by a user.

The handle 116, and indeed the whole of the front wall 112 of the computer casing 180, is protected and hidden by a front bezel 184, of the type commonly provided for personal computers. Of course, the front bezel 184 would typically be provided with suitable openings for accessing the components of the computer, such as disc drives and so on. For the sake of simplicity, these openings are not shown in Figures 9 and 10.

When a user wishes to remove the component 34 from the computer, he/she removes the front bezel 184, typically by pulling it away from the front wall 182 of the casing 180. Then, the user grasps the handle 116 and pulls it away from the front wall 182 in the manner shown in Figures 1b and 2b. This causes the frame 114 to disengage from the sub-chassis 112 and enables the component 34 to be removed from the computer. As explained above, the electrical connections with the component 34 are advantageously automatically disconnected.

Replacement of the component 34 is similarly relatively easy, in which case the user simply needs to push a frame 114 with a replacement component 34 into the sub-chassis 112 from the direction of the front wall 182 of the computer casing 180. As explained above, the positioning posts 112, 124 will be urged into the sub-chassis 112 and eventually spring out to engage the holes 30, 32 in the sub-chassis 112 to fix the frame 114 and hence the component 34 into the computer casing 180. The front bezel 184 is then simply snapped back into place.

This is a procedure which can easily be carried out by the user, avoiding completely or substantially reducing the need for this operation to be carried out by service personnel.

As explained above, in the preferred embodiment, the frame 114 is not removed from the component 34 so that the component 34 is always protected by the frame 114 during transportation and handling. Any new component 34 is supplied with its own frame 114 already secured to it.

## Claims

**1.** A component support system for supporting a component of a computer, including a frame (14, 114) within which a component (34) can be located; a handle (16,116) attached to the frame; and at least one latch (18,20; 118,120) on the frame, which latch is operably coupled to the handle and is configurable between an engaging configuration and a non-engaging configuration; wherein the handle is deformable upon the application of a force thereto and, upon such deformation, is operable to move the at least one latch to the non-engaging position.

**2.** A system according to claim 1, wherein the at least one latch (18, 20; 118, 120) is formed within the frame as a deformable part of the frame.

**3.** A system according to claim 1 or 2, wherein there are provided two latches, one either side of the handle.

**4.** A system according to any preceding claim, wherein the frame (14, 114) has internal dimensions larger than the external dimensions of the component (34).

**5.** A system according to any preceding claim, including at least one ground terminal (158) coupled to the frame.

**6.** A system according to claim 5, wherein the at least one ground terminal is movable relative to the frame.

**7.** A system according to claim 5 or 6, wherein the at least one ground terminal is in the form of a pin (158) designed to engage into a recess of a said component.

**8.** A system according to any preceding claim, wherein the frame is disengageable from a component held therein.

**10.** A system according to any preceding claim, including a sub-chassis (12, 112) within which the frame can be fixed, the sub-chassis including at least one abutment (30, 32) co-operable with said at least one latch, wherein, when the at least one latch is in the engaging configuration, the frame is latched into the sub-chassis.

**11.** A computer including a component support system according to any preceding claim.

**12.** A computer according to claim 11, wherein the computer is a personal computer.

**13.** A component assembly including a component and a component support system according to claim 1.
